# EUROPEAN PATENT APPLICATION

(11) **EP 4 503 873 A1**
(43) Date of publication of application: **05.02.2025**
(21) Application number: 23930026.2
(22) Date of filing: 30.11.2023
(51) Int. Cl.: H05K 5/00

(54) **ELECTRONIC DEVICE AND METHOD FOR ASSEMBLING ELECTRONIC DEVICE**

(30) Priority: 24.03.2023 CN 202310299959
(71) Applicant: Honor Device Co., Ltd., Shenzhen, Guangdong 518040 (CN)
(72) Inventor: ZHANG, Hongming, Shenzhen, Guangdong 518040 (CN); ZANG, Yongqiang, Shenzhen, Guangdong 518040 (CN); HUO, Guoliang, Shenzhen, Guangdong 518040 (CN)
(74) Representative: Goddar, Heinz J.
(86) International application number: PCT/CN2023/135719
(87) International publication number: WO 2024/198460

(57) **Abstract**

This application discloses an electronic device and an assembly method for the electronic device, and relates to the field of electronic product technologies. In the electronic device, connection reliability between a back cover and a middle bezel can be improved, and difficulty in assembling the electronic device can be reduced. The electronic device includes a middle bezel, a back cover, and an ultraviolet-curing tape layer, where the back cover is disposed on a side of the middle bezel, the back cover includes a substrate and an ink layer, and the ink layer is disposed on a side surface that is of the substrate and that faces the middle bezel; and the back cover is fixedly adhered to the middle bezel by using the ultraviolet-curing tape layer, the ultraviolet-curing tape layer is connected between the ink layer and the middle bezel, shear strength between the ultraviolet-curing tape layer and the ink layer is greater than or equal to 1.5 MPa, and shear strength between the ultraviolet-curing tape layer and the middle bezel is greater than or equal to 1.5 MPa.

## Description

This application claims priority to Chinese Patent Application No. 202310299959.9, filed with the China National Intellectual Property Administration on March 24, 2023 and entitled "ELECTRONIC DEVICE AND ASSEMBLY METHOD FOR ELECTRONIC DEVICE", which is incorporated herein by reference in its entirety.

### TECHNICAL FIELD

Embodiments of this application relate to the field of electronic product technologies, and in particular, to an electronic device and an assembly method for the electronic device.

### BACKGROUND

In an electronic device in a related technology, a middle bezel is usually fixedly adhered to a back cover by using at least one adhesive structure of a pressure-sensitive tape and a hot-melt adhesive. When the middle bezel is adhered to the back cover by using the pressure-sensitive tape, assembly is convenient, production efficiency is high, and processing costs are low. However, adhesive strength of the pressure-sensitive tape is poor, resulting in poor connection reliability between the back cover and the middle bezel. When the middle bezel is adhered to the back cover by using the hot-melt adhesive or the hot-melt adhesive and the pressure-sensitive tape, connection reliability between the back cover and the middle bezel can be improved. However, the hot-melt adhesive needs to be disposed on the back cover and/or the middle bezel by using an adhesive dispensing process, resulting in a complex assembly process and high processing costs. Therefore, how to improve the connection reliability between the back cover and the middle bezel and reduce difficulty in assembling the electronic device is an urgent technical problem to be resolved currently.

### SUMMARY

Embodiments of this application provide an electronic device and an assembly method for the electronic device, to improve connection reliability between a back cover and a middle bezel, and reduce difficulty in assembling the electronic device.

To achieve the foregoing objective, the following technical solutions are used in embodiments of this application.

According to a first aspect, this application provides an electronic device. The electronic device includes a middle bezel, a back cover, and an ultraviolet-curing tape layer, where the back cover is disposed on a side of the middle bezel, the back cover includes a substrate and an ink layer, and the ink layer is disposed on a side surface that is of the substrate and that faces the middle bezel; and the back cover is fixedly adhered to the middle bezel by using the ultraviolet-curing tape layer, the ultraviolet-curing tape layer is connected between the ink layer and the middle bezel, shear strength between the ultraviolet-curing tape layer and the ink layer is greater than or equal to 1.5 MPa, and shear strength between the ultraviolet-curing tape layer and the middle bezel is greater than or equal to 1.5 MPa.

In the electronic device in this application, the back cover is fixedly adhered to the middle bezel by using the ultraviolet-curing tape layer. In an assembly process, photoactivation needs to be performed only on an ultraviolet-curing tape on which photocuring processing is not performed, and lamination processing is performed on the back cover and the middle bezel, to assemble the back cover and the middle bezel. Therefore, a process is simple, processing efficiency is high, and costs are low. In addition, compared with a pressure-sensitive tape and a hot-melt adhesive, the ultraviolet-curing tape layer and the ultraviolet-curing tape are easier to clean without residue, and a repair yield can be improved. In addition, in the electronic device in this application, the shear strength between the ultraviolet-curing tape layer and the ink layer of the back cover is set to be greater than or equal to 1.5 Mpa, and the shear strength between the ultraviolet-curing tape layer and the middle bezel is set to be greater than or equal to 1.5 Mpa, to ensure adhesive strength between the ultraviolet-curing tape layer and each of the ink layer and the middle bezel. Therefore, adhesive strength between the back cover and the middle bezel can be ensured, connection reliability between the back cover and the middle bezel is improved, and a risk that the back cover is separated from the middle bezel can be reduced in a scenario in which the electronic device falls off or is impacted. In this way, in the electronic device in this application, on the basis of improving the connection reliability between the back cover and the middle bezel, a process of assembling the back cover and the middle bezel can be simplified, and difficulty in assembling the back cover and the middle bezel can be reduced. Therefore, processing costs of the electronic device can be reduced.

In a possible implementation of the first aspect, the shear strength between the ultraviolet-curing tape layer and the ink layer is less than or equal to 7 MPa. That is, a range of the shear strength between the ultraviolet-curing tape layer and the back cover is 1.5 MPa~7 MPa. In this way, the adhesive strength and an anti-impact capability between the ultraviolet-curing tape layer and the ink layer can be moderate. Therefore, the connection reliability between the back cover and the middle bezel can be ensured, and the risk that the back cover is separated from the middle bezel can be effectively reduced when the electronic device falls off or is impacted. In addition, when the electronic device falls off or when the back cover is detached in a repair process of the electronic device, the ink layer on the back cover can be prevented from being pulled off by the ultraviolet-curing tape layer. Therefore, a risk that the ink layer is peeled off can be effectively reduced, and it is conducive to prolonging a service life of the electronic device.

In a possible implementation of the first aspect, the shear strength between the ultraviolet-curing tape layer and the middle bezel is less than or equal to 7 MPa. That is, a range of the shear strength between the ultraviolet-curing tape layer and the middle bezel is 1.5 MPa~7 MPa. In this way, difficulty in detaching the back cover from the middle bezel can be reduced, and the back cover is easily detached from the middle bezel in a repair process of the electronic device. Therefore, it is conducive to improving repair efficiency and shortening a repair time. In addition, a difference between the shear strength between the ultraviolet-curing tape layer and the back cover and the shear strength between the ultraviolet-curing tape layer and the middle bezel may be reduced, so that the adhesive strength between the ultraviolet-curing tape layer and the back cover and the adhesive strength between the ultraviolet-curing tape layer and the middle bezel can be balanced generally. Therefore, uniformity of force applied to the ultraviolet-curing tape layer can be improved, and it is conducive to improving overall structural stability of the electronic device.

In a possible implementation of the first aspect, a width of at least a part of the ultraviolet-curing tape layer is less than 0.8 mm. Further, a width of the ultraviolet-curing tape layer is less than or equal to 0.5 mm. In this way, an adhesive area between the back cover and the middle bezel is reduced, so that an assembly space for components such as a battery and a circuit board can be enlarged without increasing an overall size of the electronic device, and sizes of the components such as the battery and the circuit board can be increased. Therefore, it is conducive to improving an endurance capability of the electronic device, expanding a function of the electronic device, and optimizing performance of the electronic device. In addition, it is further conducive to reducing the size of the electronic device, and implementing a thin and lightweight design of the electronic device.

In a possible implementation of the first aspect, a width of at least a part of the ultraviolet-curing tape layer is greater than or equal to 0.25 mm. For example, a width w of the ultraviolet-curing tape layer may be 0.25 mm, 0.3 mm, 0.35 mm, 0.4 mm, 0.45 mm, 0.5 mm, 0.6 mm, 0.7 mm, 0.8 mm, or the like. In this way, the adhesive strength between the back cover and the middle bezel can be ensured.

In a possible implementation of the first aspect, a width of at least a part of the ultraviolet-curing tape layer is greater than or equal to 0.25 mm and less than or equal to 0.5 mm. In this way, the adhesive strength between the back cover and the middle bezel can be ensured, and an adhesive area between the back cover and the middle bezel is reduced, so that an assembly space for components such as a battery and a circuit board can be enlarged without increasing an overall size of the electronic device, and sizes of the components such as the battery and the circuit board can be increased. Therefore, it is conducive to improving an endurance capability of the electronic device, expanding a function of the electronic device, and optimizing performance of the electronic device. In addition, it is further conducive to reducing the size of the electronic device, and implementing a thin and lightweight design of the electronic device.

In a possible implementation of the first aspect, a thickness of the ultraviolet-curing tape layer is greater than or equal to 0.15 mm and less than or equal to 0.45 mm. In this way, photoactivation is easily performed on the ultraviolet-curing tape by using ultraviolet light, to ensure connection strength between the back cover and the middle bezel, and improve an anti-fall capability of the electronic device. In addition, sizes of the middle bezel, the ultraviolet-curing tape layer, and the back cover in a thickness direction (that is, a Z-axis direction) of the electronic device can be reduced. In addition, a flatness problem in manufacturing the back cover and the middle bezel can be effectively absorbed, and an assembly yield of the back cover and the middle bezel can be improved.

In a possible implementation of the first aspect, the ultraviolet-curing tape layer is formed by performing photocuring processing on an ultraviolet-curing tape, the ultraviolet-curing tape includes a matrix, a first adhesive film, and a second adhesive film, the matrix is a transparent member, the matrix includes a first surface and a second surface that are opposite to each other, and the first surface faces the back cover; the first adhesive film is disposed on the first surface of the matrix, and the first adhesive film is configured to be fixedly adhered to the back cover; and the second adhesive film is disposed on the second surface of the matrix, the second adhesive film is configured to be fixedly adhered to the middle bezel, and the first adhesive film and the second adhesive film each include an ultraviolet-curing composition. In this embodiment, the ultraviolet-curing tape has a simple structure and is easy to process. In addition, the ultraviolet-curing composition in the first adhesive film and the ultraviolet-curing composition in the second adhesive film may be adjusted based on materials of the middle bezel and the back cover, so that shear strength between the cured first adhesive film and the ink layer of the back cover and shear strength between the cured second adhesive film and the middle bezel are moderate.

In a possible implementation of the first aspect, the ultraviolet-curing composition in the first adhesive film is the same as the ultraviolet-curing composition in the second adhesive film.

In a possible implementation of the first aspect, light transmittance of the matrix is greater than or equal to 92%. In this way, when the ultraviolet-curing tape is disposed on the back cover, the second adhesive film may be exposed, so that the second adhesive film can be directly activated by using ultraviolet light, and the first adhesive film can be activated by using the ultraviolet light passing through the matrix. Similarly, when the ultraviolet-curing tape is disposed on the middle bezel, the first adhesive film may be exposed, so that the first adhesive film can be directly activated by using ultraviolet light, and the second adhesive film 633 can be activated by using the ultraviolet light passing through the matrix. Therefore, ultraviolet activation processing is easily performed on the ultraviolet-curing tape.

In a possible implementation of the first aspect, the matrix is a transparent plastic member. For example, a material of the matrix may include at least one of polyethylene terephthalate (polyethylene terephthalate, PET), polymethyl methacrylate (polymethyl methacrylate, PMMA), or polycarbonate (polycarbonate, PC). The transparent plastic member has good light transmittance, a low price, and is easy to obtain.

In a possible implementation of the first aspect, the ultraviolet-curing tape layer is formed by performing photocuring processing on an ultraviolet-curing tape, the ultraviolet-curing tape includes a first adhesive film, the first adhesive film includes an ultraviolet-curing composition, the first adhesive film includes a first adhesive surface and a second adhesive surface that face away from each other, the first adhesive surface is configured to be adhered to the back cover, and the second adhesive surface is configured to be adhered to the middle bezel. In this way, the middle bezel can also be fixedly adhered to the back cover, and the ultraviolet-curing tape has a simple structure, and is easy to process.

In a possible implementation of the first aspect, the ultraviolet-curing composition includes an acrylic polymer, a curable component, and a photo base generator, and a monomer of the acrylic polymer includes an acryloyl monomer containing a hydroxyl functional group; and the curable component includes multi-functional thiol and multi-functional epoxy resin.

The hydroxyl functional group and a material of the ink layer have good wettability. When the monomer of the acrylic polymer includes the acryloyl monomer containing the hydroxyl functional group, wettability between the ultraviolet-curing composition and the ink layer can be improved, and the shear strength between the ultraviolet-curing tape layer and the back cover can be improved, so that the ultraviolet-curing tape layer can be applied to adhesion of interfaces such as a metal interface, a PC interface, and a PMMA interface, and can be applied to adhesion of an interface including the ink layer. Therefore, the ultraviolet-curing tape layer can be applied to adhesion of a plurality of interfaces of different materials.

In a possible implementation of the first aspect, in the ultraviolet-curing tape layer, a ratio of a mass of the acrylic polymer to a mass of the ultraviolet-curing composition is greater than or equal to 60%. That is, a mass fraction of the acrylic polymer in the ultraviolet-curing tape layer is greater than or equal to 60%. In this way, the mass fraction of the acrylic polymer in the ultraviolet-curing tape layer is set to be greater than or equal to 60%. In this case, the shear strength between the ultraviolet-curing tape layer and the back cover can be controlled to be 1.5 MPa~7 MPa, the adhesive strength between the ultraviolet-curing tape layer and the ink layer can be significantly improved, and the ink layer on the back cover can be prevented from being pulled off by the ultraviolet-curing tape layer in a scenario in which the electronic device falls off or the back cover is detached in a repair process of the electronic device. Therefore, a risk that the ink layer is peeled off can be effectively reduced, and it is conducive to prolonging a service life of the electronic device. In addition, initial adhesion of the ultraviolet-curing tape can be significantly improved, and positioning performance of the ultraviolet-curing tape layer can be improved.

In a possible implementation of the first aspect, the middle bezel includes a middle plate and a bezel, the bezel is connected to an outer edge of the middle plate, and the ultraviolet-curing tape layer is connected between the middle plate and the back cover. A specific connection manner is provided.

In a possible implementation of the first aspect, the bezel is formed at the edge of the middle plate by using an injection molding process. In this way, connection strength between the bezel and the middle plate can be improved, and processing costs of the middle bezel can be reduced.

In a possible implementation of the first aspect, the middle plate is a metal member, a polymethyl methacrylate member, or a polycarbonate member. In this way, structural strength of the middle bezel can be ensured, and the middle bezel can be fixedly adhered to the back cover by using the ultraviolet-curing tape layer.

In a possible implementation of the first aspect, the electronic device further includes a screen, and the screen is disposed on a side that is of the middle bezel and that faces away from the back cover.

In a possible implementation of the first aspect, initial adhesion between the ultraviolet-curing tape and the back cover is greater than or equal to 0.2 N/mm. In this way, adhesive strength between the ultraviolet-curing tape on which photocuring processing is not performed and the back cover can be ensured, and the ultraviolet-curing tape on which photocuring processing is not performed can be prevented from being slipped off from the back cover. Therefore, positioning reliability between the ultraviolet-curing tape on which photocuring processing is not performed and the back cover can be improved, the difficulty in assembling the back cover and the middle bezel can be reduced, and an assembly yield of the electronic device can be improved.

In a possible implementation of the first aspect, initial adhesion between the ultraviolet-curing tape and the back cover is less than or equal to 1 N/mm. In this way, difficulty in processing the ultraviolet-curing tape can be reduced, and processing costs of the ultraviolet-curing tape can be reduced. Therefore, overall costs of the electronic device can be reduced.

In a possible implementation of the first aspect, initial adhesion between the ultraviolet-curing tape and the middle bezel is greater than or equal to 0.2 N/mm.

In a possible implementation of the first aspect, initial adhesion between the ultraviolet-curing tape and the middle bezel is less than or equal to 1 N/mm.

In a possible implementation of the first aspect, a die-cuttable width of the ultraviolet-curing tape is less than 0.8 mm. Further, the die-cuttable width of the ultraviolet-curing tape is less than or equal to 0.5 mm. The die-cuttable width of the ultraviolet-curing tape is a die-cut width used for the ultraviolet-curing tape when photocuring processing is not performed on the ultraviolet-curing tape. In this way, in actual application, die cutting may be performed on the ultraviolet-curing tape based on an actual requirement, so that the ultraviolet-curing tape is die-cut to a required width. Because the die-cuttable width of the ultraviolet-curing tape is small, different requirements of different adhesive parts for a width of the ultraviolet-curing tape layer can be met, so that the middle bezel can be more flexibly adhered to the back cover. Therefore, components inside the electronic device are easily assembled, and it is conducive to enlarging an assembly space of the electronic device for the components such as a battery and a circuit board.

According to a second aspect, this application provides an assembly method for an electronic device, including: providing a first structural member, where the first structural member includes a first adhesive region; disposing an uncured ultraviolet-curing tape in the first adhesive region of the first structural member; performing ultraviolet irradiation on the first adhesive region in which the ultraviolet-curing tape is disposed, to activate the ultraviolet-curing tape; providing a second structural member that includes a second adhesive region, disposing the second structural member on a side of the first structural member, and connecting the ultraviolet-curing tape between the first adhesive region and the second adhesive region, to form a first blank; and performing pressure maintaining processing on the first blank for preset duration, to form an ultraviolet-curing tape layer based on the ultraviolet-curing tape, where the first structural member includes a back cover, the second structural member includes a middle bezel, the first adhesive region is located on an ink layer of the back cover, and the second adhesive region is located on the middle bezel; or the first structural member includes a middle bezel, the second structural member includes a back cover, the first adhesive region is located on the middle bezel, and the second adhesive region is located on an ink layer of the back cover.

In the assembly method for an electronic device in this application, in an assembly process, photoactivation needs to be performed only on the uncured ultraviolet-curing tape, and lamination processing is performed on the first structural member and the second structural member, to assemble the first structural member and the second structural member. Therefore, a process is simple, processing efficiency is high, and costs are low. In addition, the ultraviolet-curing tape layer is formed after the ultraviolet-curing tape is cured, so that connection strength between the first structural member and the second structural member can be ensured. Therefore, adhesive strength between the back cover and the middle bezel can be ensured, connection reliability between the back cover and the middle bezel is improved, and a risk that the back cover is separated from the middle bezel can be reduced in a scenario in which the electronic device falls off or is impacted. In addition, compared with a pressure-sensitive tape and a hot-melt adhesive, the ultraviolet-curing tape layer and the ultraviolet-curing tape are easier to clean without residue, and a repair yield of the electronic device can be improved.

In a possible implementation of the second aspect, the performing pressure maintaining processing on the first blank for preset duration includes: performing pressure maintaining processing on the first blank by using a pressure maintaining fixture for 60s~120s. Processing efficiency is high, and it is conducive to reducing processing costs.

In a possible implementation of the second aspect, a die-cuttable width of the ultraviolet-curing tape is less than 0.8 mm. Further, the die-cuttable width of the ultraviolet-curing tape is less than or equal to 0.5 mm. The die-cuttable width of the ultraviolet-curing tape is a die-cut width used for the ultraviolet-curing tape when photocuring processing is not performed on the ultraviolet-curing tape. In this way, in actual application, die cutting may be performed on the ultraviolet-curing tape based on an actual requirement, so that the ultraviolet-curing tape is die-cut to a required width. Because the die-cuttable width of the ultraviolet-curing tape is small, different requirements of different adhesive parts for a width of the ultraviolet-curing tape layer can be met, so that the middle bezel can be more flexibly adhered to the back cover. Therefore, components inside the electronic device are easily assembled, and it is conducive to enlarging an assembly space of the electronic device for the components such as a battery and a circuit board.

In some embodiments, initial adhesion between the ultraviolet-curing tape and the first adhesive region is greater than or equal to 0.2 N/mm. Specifically, when the first adhesive region is located on the ink layer, initial adhesion between the ultraviolet-curing tape and the ink layer is greater than or equal to 0.2 N/mm. When the first adhesive region is located on the middle bezel, initial adhesion between the ultraviolet-curing tape and the middle bezel is greater than or equal to 0.2 N/mm. In this way, adhesive strength between the uncured ultraviolet-curing tape and the first adhesive region can be ensured, the uncured ultraviolet-curing tape can be prevented from being slipped off from the first adhesive region, and positioning reliability between the uncured ultraviolet-curing tape and the first structural member can be improved. Therefore, difficulty in assembling the electronic device can be reduced, and it is conducive to improving an assembly yield of the electronic device.

In a possible implementation of the second aspect, the ultraviolet-curing tape includes a matrix, a first adhesive film, and a second adhesive film, the matrix is a transparent member, the matrix includes a first surface and a second surface that are opposite to each other, and the first surface faces the back cover; the first adhesive film is disposed on the first surface of the matrix, and the first adhesive film is configured to be fixedly adhered to the back cover; and the second adhesive film is disposed on the second surface of the matrix, the second adhesive film is configured to be fixedly adhered to the middle bezel, and the first adhesive film and the second adhesive film each include an ultraviolet-curing composition.

In a possible implementation of the second aspect, the ultraviolet-curing tape includes a first adhesive film, the first adhesive film includes an ultraviolet-curing composition, the first adhesive film includes a first adhesive surface and a second adhesive surface that face away from each other, the first adhesive surface is configured to be adhered to the back cover, and the second adhesive surface is configured to be adhered to the middle bezel.

In a possible implementation of the second aspect, the ultraviolet-curing composition includes an acrylic polymer, a curable component, and a photo base generator, and a monomer of the acrylic polymer includes an acryloyl monomer containing a hydroxyl functional group; and the curable component includes multi-functional thiol and multi-functional epoxy resin.

In a possible implementation of the second aspect, a thickness of the ultraviolet-curing tape is greater than or equal to 0.15 mm and less than or equal to 0.45 mm. In this way, the thickness of the ultraviolet-curing tape layer can be controlled in a range of 0.15 mm~0.45 mm.

For technical effects brought by any one of design manners in the second aspect, refer to the technical effects brought by different design manners in the first aspect. Details are not described herein again.

### BRIEF DESCRIPTION OF DRAWINGS

FIG. 1 is a three-dimensional view of an electronic device according to some embodiments of this application;
FIG. 2 is an exploded view of the electronic device shown in FIG. 1;
FIG. 3 is a cross-sectional view of the electronic device shown in FIG. 1 that is taken along a line A-A;
FIG. 4 is a schematic diagram of a partial cross section of a back cover according to some embodiments of this application;
FIG. 5 is a schematic diagram of assembly of a back cover and an adhesive structure according to some embodiments of this application;
FIG. 6 is a schematic diagram of assembly of a back cover and an adhesive structure according to some other embodiments of this application;
FIG. 7 is a cross-sectional view of an electronic device according to some other embodiments of this application;
FIG. 8 is a schematic diagram of a stacked structure of an ultraviolet-curing tape according to some embodiments of this application;
FIG. 9 is a schematic diagram of a structure of an ultraviolet-curing tape according to some other embodiments of this application;
FIG. 10 is a flowchart of an assembly method for an electronic device according to some embodiments of this application;
FIG. 11 is a schematic flowchart of an assembly method for an electronic device according to some embodiments of this application; and
FIG. 12 is an enlarged view of a region A in the schematic flowchart shown in FIG. 11.

### Reference numerals:

100-electronic device; 10-screen; 20-middle bezel; 21-bezel; 22-middle plate; 221-assembly groove; 30-circuit board; 31-primary circuit board; 32-secondary circuit board; 40-battery; 50-back cover; 51-substrate; 511-first inner surface; 512-first outer surface; 52-ink layer; 501-first adhesive region; 60-adhesive structure; 61-pressure-sensitive tape; 62-hot-melt adhesive; 63-ultraviolet-curing tape layer; 630-ultraviolet-curing tape; 631-matrix; 631a-first surface; 631b-second surface; 632-first adhesive film; and 633-second adhesive film.

### DESCRIPTION OF EMBODIMENTS

In embodiments of this application, words such as "example" or "for example" are used to represent giving an example, an illustration, or a description. Any embodiment or design solution described as "example" or "for example" in embodiments of this application should not be construed as being more preferred or advantageous than other embodiments or design solutions. Exactly, the words such as "example" or "for example" are used to present related concepts in a specific manner.

In embodiments of this application, the terms "first" and "second" are merely used for the purpose of description, and should not be understood as an indication or implication of relative importance or an implicit indication of a quantity of indicated technical features. Therefore, features defined with "first" or "second" may explicitly or implicitly include one or more of the features.

In the description of embodiments of this application, the term "at least one" means one or more, and "a plurality of" means two or more. "At least one of the following items" or a similar expression means any combination of these items, including any combination of a single item or a plurality of items. For example, at least one of a, b, or c may represent a, b, c, a-b, a-c, b-c, or a-b-c, where a, b, and c may be singular or plural.

In the descriptions of embodiments of this application, the term "and/or" is merely used to describe an association relationship between associated objects, and represents that three relationships may exist. For example, A and/or B may represent the following three cases: Only A exists, both A and B exist, and only B exists. In addition, the character "/" in this application usually represents an "or" relationship between associated objects.

In the description of embodiments of this application, it should be noted that unless otherwise specified and defined explicitly, the terms "mount", "connect", and "connection" should be understood in a broad sense. For example, "connection" may be a detachable connection or a non-detachable connection; or may be a direct connection or an indirect connection through an intermediate medium. A "fixed connection" means that there is a mutual connection and a relative position relationship remains unchanged after the connection. A "rotatable connection" means that there is a mutual connection and relative rotation can be implemented after the connection. A "slidable connection" means that there is a mutual connection and relative sliding can be implemented after the connection.

Orientation terms such as "inside", "outside", "upper", "lower", "front", "rear", "left", and "right" mentioned in embodiments of this application are merely directions in the accompanying drawings. Therefore, the used orientation terms are intended for better and clearer description and understanding of embodiments of this application, and are not intended for indicating or implying that an indicated apparatus or element needs to have a specific orientation or constructed and operated in a specific orientation, and therefore should not be construed as limitations on embodiments of this application.

In the descriptions of embodiments of this application, the term "include", "have", or any other variant thereof is intended to cover non-exclusive inclusion, so that a process, method, article, or apparatus that includes a series of elements includes not only those elements but also other elements that are not explicitly listed, or includes elements inherent to such a process, method, article, or apparatus. Without further limitation, the element defined by the sentence "including a..." does not exclude that other identical elements also exist in the process, method, article, or apparatus including the element.

This application provides an electronic device. The electronic device includes but is not limited to an electronic device such as a mobile phone, a tablet personal computer (tablet personal computer), a laptop computer (laptop computer), a personal digital assistant (personal digital assistant, PDA), a personal computer, a notebook computer, a vehicle-mounted device, or a wearable device. The wearable device includes but is not limited to a watch or a bracelet.

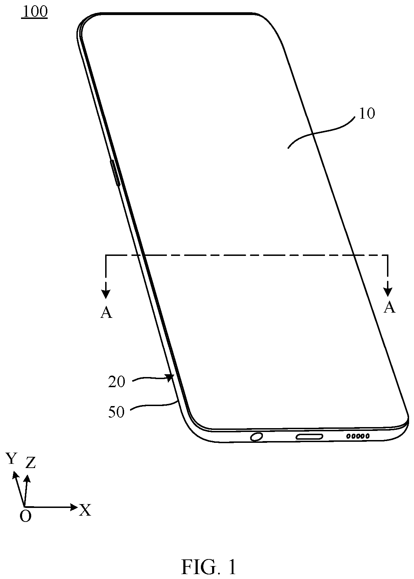

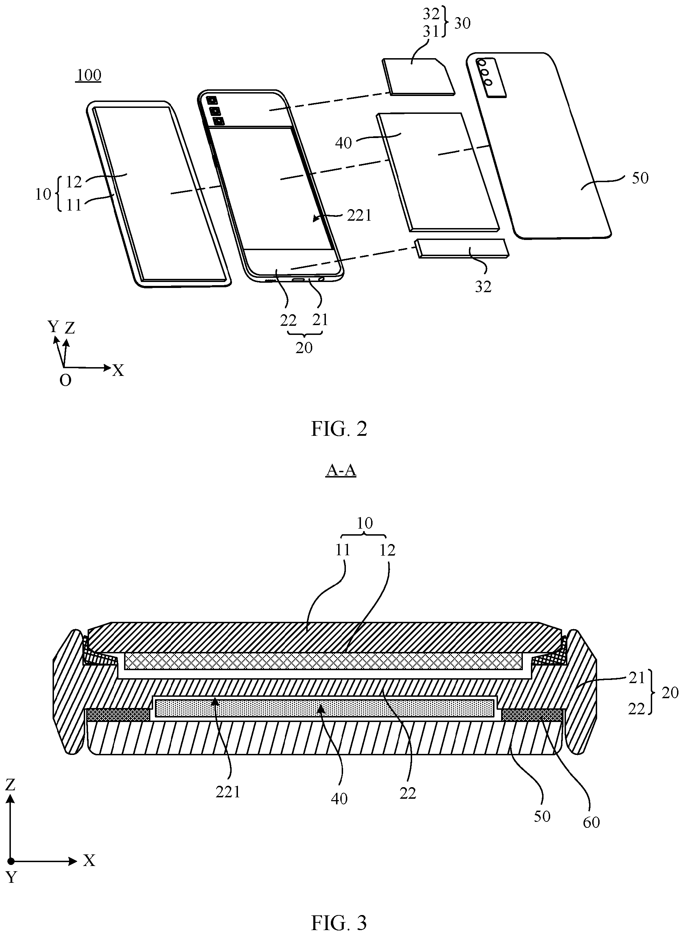

Refer to FIG. 1-FIG. 2. FIG. 1 is a three-dimensional view of an electronic device 100 according to some embodiments of this application, and FIG. 2 is an exploded view of the electronic device 100 shown in FIG. 1. The electronic device 100 in this embodiment is described by using a phablet as an example. It may be understood that, in another embodiment, the electronic device 100 may alternatively be a foldable mobile phone. Refer to FIG. 1-FIG. 2. In this example, the electronic device 100 includes a screen 10, a middle bezel 20, a circuit board 30 (not shown in FIG. 1), a battery 40 (not shown in FIG. 1), and a back cover 50 (which may also be referred to as a battery cover).

It may be understood that FIG. 1, FIG. 2, and the following related accompanying drawings schematically show only some components included in the electronic device 100. Actual shapes, actual sizes, actual positions, and actual structures of these components are not limited to FIG. 1, FIG. 2, and the following accompanying drawings. In addition, when the electronic device 100 is a device in some other forms, the electronic device 100 may alternatively not include the screen 10.

In the embodiment shown in FIG. 1, the electronic device 100 is in a shape of a rectangular flat plate. For ease of description of the following embodiments, an XYZ coordinate system is established. Specifically, a width direction of the electronic device 100 is defined as an X-axis direction, a length direction of the electronic device 100 is defined as a Y-axis direction, and a thickness direction of the electronic device 100 is defined as a Z-axis direction. It may be understood that the coordinate system of the electronic device 100 may be flexibly set based on an actual requirement, and is not specifically limited herein. In some other embodiments, a shape of the electronic device 100 may alternatively be a shape of a square flat plate, a circular flat plate, an oval flat plate, or the like.

The screen 10 is configured to display an image, a video, or the like. Refer to FIG. 2. The screen 10 includes a light-transmitting cover plate 11 and a display 12. The light-transmitting cover plate 11 and the display 12 are stacked. The light-transmitting cover plate 11 is mainly configured to protect the display 12 and prevent dust. The display 12 may be a flexible display, or may be a rigid display. For example, the display 12 may be an organic light-emitting diode (organic light-emitting diode, OLED) display, a liquid crystal display (liquid crystal display, LCD), or the like.

The middle bezel 20 forms a part of a housing of the electronic device 100. That is, the housing of the electronic device 100 includes the middle bezel 20. The middle bezel 20 serves as a support skeleton of the electronic device 100, and is configured to mount electronic components such as the screen 10, the circuit board 30, and the battery 40. Refer to FIG. 2 and FIG. 3. FIG. 3 is a cross-sectional view of the electronic device 100 shown in FIG. 1 that is taken along a line A-A. The middle bezel 20 includes a bezel 21 and a middle plate 22. The bezel 21 is in a ring shape. The middle plate 22 is fastened to an inner surface of the bezel 21. The bezel 21 may surround an edge of the middle plate 22 by one round. The screen 10 may be fastened to the middle bezel 20 by using the light-transmitting cover plate 11. Specifically, the light-transmitting cover plate 11 may be fastened to the bezel 21 or the middle plate 22 of the middle bezel 20.

In some embodiments, the middle plate 22 is a metal member. Specifically, the middle plate 22 may be made of a metal material with large structural strength and hardness, so that the middle plate 22 has large structural strength, and the middle plate 22 can play a role of stable support. For example, a material of the middle plate 22 may be aluminum alloy, stainless steel, or the like. In some other embodiments, the middle plate 22 may alternatively be a plastic member. In this case, the material of the middle plate 22 may be polymethyl methacrylate (polymethyl methacrylate, PMMA), polycarbonate (polycarbonate, PC), or the like.

The bezel 21 may be formed at the edge of the middle plate 22 by using an injection molding process. Specifically, the bezel 21 is a plastic member. For example, a material of the bezel 21 may be PMMA, PC, or the like. In this way, connection strength between the bezel 21 and the middle plate 22 can be improved, and processing costs of the middle bezel 20 can be reduced.

It may be understood that, in another embodiment, the middle bezel 20 may alternatively be an integrated member, or the middle plate 22 may be fixedly connected to the bezel 21 in a manner of gluing, welding, clamping, or the like. Still refer to FIG. 2. The circuit board 30 includes a primary circuit board 31 and a secondary circuit board 32. Both the primary circuit board 31 and the secondary circuit board 32 are fixedly connected to a side surface that is of the middle plate 22 and that faces away from the screen 10, and the primary circuit board 31 and the secondary circuit board 32 are spaced apart. For example, the primary circuit board 31 and the secondary circuit board 32 are spaced apart in the Y-axis direction.

The primary circuit board 31 is configured to integrate a control chip. The control chip may be, for example, an application processor (application processor, AP), a double data rate (double data rate, DDR) synchronous dynamic random access memory, and a universal flash storage (universal flash storage, UFS).

The secondary circuit board 32 is configured to integrate electronic components such as a radio frequency front end of an antenna (for example, a 5G antenna), a universal serial bus (universal serial bus, USB) component, and an oscillator. A socket may be disposed at a position that is on the bezel 21 and that corresponds to the USB component, and accessories such as a charger, a headset, and a data line may be electrically connected to the USB component through the socket, to implement power, signal, and data transmission. The secondary circuit board 32 is electrically connected to the primary circuit board 31, to implement data and signal transmission between the primary circuit board 31 and the secondary circuit board 32. It may be understood that, in another embodiment, the circuit board 30 may alternatively include only the primary circuit board 31, but not the secondary circuit board 32.

The battery 40 is configured to provide power to the display 12, the circuit board 30, and the like. Refer to FIG. 2 and FIG. 3. The battery 40 may be fixedly connected to the side surface that is of the middle plate 22 and that faces away from the screen 10. For example, the battery 40 may be disposed between the primary circuit board 31 and the secondary circuit board 32. An assembly groove 221 is disposed on the side surface that is of the middle plate 22 and that faces away from the screen 10, and the battery 40 may be mounted in the assembly groove 221. In this way, it is conducive to reducing an overlay size of the battery 40 and the middle plate 22 in the Z-axis direction, and it is conducive to reducing an overall thickness of the electronic device 100.

The back cover 50 forms a part of the housing of the electronic device 100, and is configured to protect electronic components such as the primary circuit board 31, the secondary circuit board 32, and the battery 40 inside the electronic device 100. That is, the housing of the electronic device 100 includes the back cover 50. Still refer to FIG. 2 and FIG. 3. The back cover 50 is located on a side that is of the middle plate 22 and that is away from the screen 10, and the back cover 50 is fastened to the middle bezel 20. The back cover 50 and the middle bezel 20 enclose an accommodating cavity configured to accommodate the primary circuit board 31, the secondary circuit board 32, the battery 40, and the like. Optionally, the back cover 50 may be a 2D back cover, a 2.5D back cover, or a 3D back cover.

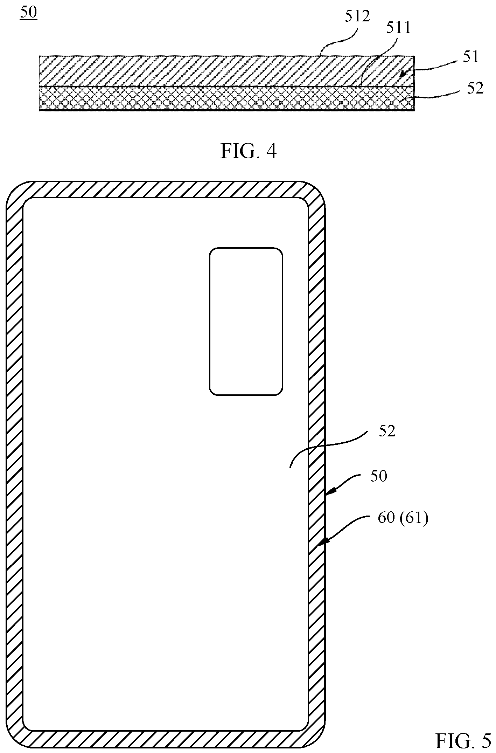

Refer to FIG. 4. FIG. 4 is a schematic diagram of a partial cross section of the back cover 50 according to some embodiments of this application. The back cover 50 includes a substrate 51 and an ink layer 52. It may be understood that FIG. 4 and the following related accompanying drawings schematically show only some stacked structures included in the back cover 50. Actual thicknesses and actual structures of these stacked structures are not limited to FIG. 4 and the following accompanying drawings. In addition, the stacked structures of the back cover 50 are not limited to the substrate 51 and the ink layer 52. In another embodiment, in addition to the substrate 51 and the ink layer 52, the back cover 50 may further include another film layer disposed on a side surface that is of the substrate 51 and that faces away from 52, and/or another film layer disposed between the substrate 51 and the ink layer 52.

The substrate 51 may be a transparent member. The substrate 51 includes a first inner surface 511 and a first outer surface 512 that face away from each other. The first inner surface 511 of the substrate 51 faces the middle bezel. In some embodiments, the substrate 51 may be a polymethyl methacrylate (polymethyl methacrylate, PMMA) plate, a polycarbonate (polycarbonate, PC) plate, a composite plate formed through stacking of a polymethyl methacrylate plate and a polycarbonate plate, glass, or the like.

The ink layer 52 is disposed on a side that is of the substrate 51 and that the first inner surface 511 faces. The ink layer 52 may be configured to decorate the back cover 50. The ink layer 52 may be an ink layer 52 with a single color, or may be an ink layer 52 with a particular decorative pattern.

Because the substrate 51 is a transparent member, the ink layer 52 may be exposed to the first outer surface 512 of the substrate 51 through the substrate 51. In this way, a user can see the ink layer 52 from the outside of the electronic device 100. Therefore, appearance aesthetics of the electronic device 100 can be improved, to meet a requirement of the user for an appearance of the electronic device 100. In addition, the user does not touch the ink layer 52 in a process of using the electronic device 100, so that the ink layer 52 can be prevented from being scratched by a hard object. Therefore, it is conducive to improving service lives of the back cover 50 and the electronic device 100.

It may be understood that the ink layer 52 may include one or more layers. A material of the ink layer 52 may include major resin. The major resin includes but is not limited to polyester resin. The ink layer 52 may be formed on the substrate 51 in a manner of silk screen, transfer, or the like. In some embodiments, to improve printability and a printing effect of the ink layer 52, the material of the ink layer 52 may further include matte powder. Specifically, the matte powder may include precipitated silicon dioxide and bentonite.

Refer back to FIG. 3. The electronic device 100 further includes an adhesive structure 60, and the adhesive structure 60 is connected between the back cover 50 and the middle bezel 20. Specifically, the adhesive structure 60 is connected between the back cover 50 and the middle plate 22. In this way, the back cover 50 can be adhered to the middle bezel 20 by using the adhesive structure 60.

Specifically, in some embodiments, refer to FIG. 5. FIG. 5 is a schematic diagram of assembly of the back cover 50 and the adhesive structure 60 according to some embodiments of this application. In this embodiment, the adhesive structure 60 includes a pressure-sensitive tape 61. The pressure-sensitive tape 61 may be adhered to an inner surface of the back cover 50, and the pressure-sensitive tape 61 may be disposed on an edge part of the inner surface of the back cover 50. Specifically, the pressure-sensitive tape 61 may be connected between the ink layer 52 of the back cover 50 and the middle bezel 20.

The pressure-sensitive tape 61 is a special type of tape, and is made by applying a special adhesive (pressure-sensitive adhesive) to the strip-shaped substrate 51. The pressure-sensitive tape 61 includes but is not limited to a foam tape (which may also be referred to as a foam pressure-sensitive tape).

The pressure-sensitive tape 61 may be directly adhered to the back cover 50 or the middle bezel 20 after being formed through die cutting, so that the back cover 50 and the middle bezel 20 are assembled together by using a positioning fixture. In a process of adhering the back cover 50 to the middle bezel 20 by using the pressure-sensitive tape 61, the back cover 50 can be adhered to the middle bezel 20 by applying only a slight pressure, and there is no need to perform high-temperature curing for a long time or at a temperature greater than 160°C. Therefore, assembly is convenient, production efficiency is high, and processing costs are low.

However, adhesive strength of the pressure-sensitive tape 61 is poor, and shear strength between the pressure-sensitive tape 61 and the back cover 50 and shear strength between the pressure-sensitive tape 61 and the middle bezel 20 usually do not exceed 1.3 MPa, resulting in poor connection reliability between the back cover 50 and the middle bezel 20. When mechanical reliability tests such as a tumbling test are performed on the electronic device 100, the back cover 50 is easily separated from the middle bezel 20, and structural stability of the electronic device 100 cannot be ensured. In addition, a die-cuttable width of the pressure-sensitive tape 61 is large, and is usually more than 0.8 mm. Otherwise, a die-cut yield of the pressure-sensitive tape 61 cannot be ensured. In this case, an adhesive area between the back cover 50 and the middle bezel is large, which is not conducive to implementing a thin and lightweight design of the electronic device 100, and limits further enlargement of an assembly space inside the electronic device 100 for components such as the battery 40 and the circuit board 30. Consequently, it is not conducive to implementing endurance capability improvement and performance optimization of the electronic device 100.

It should be noted that the "adhesive strength" described in this application refers to stress required to cause damage to an interface between the adhesive structure 60 (for example, the pressure-sensitive tape 61, a hot-melt adhesive 62, and an ultraviolet-curing tape layer described below) and an adhered object or to a nearby position of the interface under the action of an external force. The adhesive strength is also referred to as bonding strength. The shear strength is one of representation manners of the adhesive strength. The shear strength, which may also be referred to as dynamic shear strength, lap shear strength, or the like, refers to stress required to cause damage to the interface between the adhesive structure 60 (for example, the pressure-sensitive tape 61, the hot-melt adhesive 62, or the ultraviolet-curing tape layer) and the adhered object or to the nearby position of the interface under the action of an external force in a direction parallel to an adhesive surface. The shear strength may be tested with reference to GBIT 33332-2016 "Test Method for Dynamic Shear Strength of Adhesive Tapes".

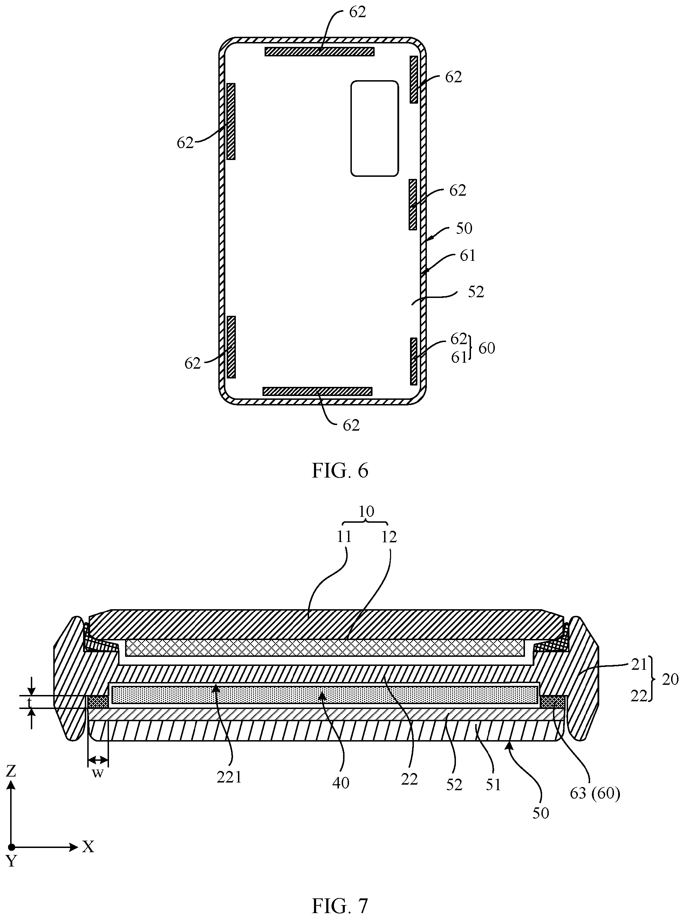

In some embodiments, to improve the connection reliability between the back cover 50 and the middle bezel 20, refer to FIG. 6. FIG. 6 is a schematic diagram of assembly of the back cover 50 and the adhesive structure 60 according to some other embodiments of this application. In this embodiment, in addition to the pressure-sensitive tape 61, the adhesive structure 60 further includes a hot-melt adhesive 62. In this case, the back cover 50 may be adhered to the middle bezel 20 by using the hot-melt adhesive 62 and the pressure-sensitive tape 61. It may be understood that, in another embodiment, the adhesive structure 60 may alternatively include only the hot-melt adhesive 62, but not the pressure-sensitive tape 61.

A full name of the hot-melt adhesive 62 is a moisture-curing polyurethane reactive (polyurethane reactive, PUR) hot-melt adhesive 62, and a main component is an isocyanate-terminated polyurethane prepolymer. Because adhesive strength of the hot-melt adhesive 62 is strong, shear strength between the hot-melt adhesive 62 and the back cover 50 and shear strength between the hot-melt adhesive 62 and the middle bezel 20 may be more than 14 Mpa.

In this way, the hot-melt adhesive 62 is disposed between the back cover 50 and the middle bezel 20, to improve connection strength between the back cover 50 and the middle bezel 20, and improve the connection reliability between the back cover 50 and the middle bezel 20. However, the hot-melt adhesive 62 needs to be disposed on the back cover 50 and/or the middle bezel 20 by using an adhesive dispensing process, resulting in a complex assembly process and high processing costs. In addition, the shear strength between the hot-melt adhesive 62 and the back cover 50 is large. When usage of the hot-melt adhesive 62 is large, and when the electronic device 100 falls off or the back cover 50 needs to be detached in a repair process, the ink layer 52 on the back cover 50 is easily pulled off by the hot-melt adhesive 62, there is a risk that the ink layer 52 is peeled off, and an appearance of the back cover 50 is prone to being damaged.

To simplify a process of assembling the back cover 50 and the middle bezel 20 and reduce difficulty in assembling the back cover 50 and the middle bezel 20 on the basis of improving the connection reliability between the back cover 50 and the middle bezel 20, refer to FIG. 7. FIG. 7 is a cross-sectional view of an electronic device 100 according to some other embodiments of this application. In the electronic device 100 in this embodiment, the adhesive structure 60 includes an ultraviolet-curing tape layer 63, and the back cover 50 is fixedly adhered to the middle bezel 20 by using the ultraviolet (ultraviolet, UV)-curing tape layer 63. Specifically, the ultraviolet-curing tape layer 63 is connected between the ink layer 52 and the middle bezel 20.

The ultraviolet-curing tape layer 63 may be formed by performing photocuring processing on an ultraviolet-curing tape. "Photocuring processing" refers to a process in which medium and short waves (300 nanometers~800 nanometers) in ultraviolet light are used, and a photoinitiator in a material is stimulated to become free radicals or cations under ultraviolet radiation, so that a polymer material (resin) containing an active functional group is polymerized into a solid film.

The ultraviolet-curing tape is a tape with initial adhesion, and may be cured to form the ultraviolet-curing tape layer 63 after being activated through ultraviolet irradiation. That is, the ultraviolet-curing tape layer 63 is a cured ultraviolet-curing tape.

Shear strength between the ultraviolet-curing tape layer 63 and the ink layer 52 of the back cover 50 is greater than or equal to 1.5 Mpa, and shear strength between the ultraviolet-curing tape layer 63 and the middle bezel 20 is greater than or equal to 1.5 Mpa. For example, the shear strength between the ultraviolet-curing tape layer 63 and the ink layer 52 may be 1.5 MPa, 1.6 MPa, 1.8 MPa, 2 MPa, 2.5 MPa, 3 MPa, 3.5 MPa, 4 MPa, 4.5 MPa, 5 MPa, 5.5 MPa, 6 MPa, 6.5 MPa, 7 MPa, or the like. The shear strength between the ultraviolet-curing tape layer 63 and the middle bezel 20 may be 1.5 MPa, 1.6 MPa, 1.8 MPa, 2 MPa, 2.5 MPa, 3 MPa, 3.5 MPa, 4 MPa, 4.5 MPa, 5 MPa, 5.5 MPa, 6 MPa, 6.5 MPa, 7 MPa, 8 MPa, 9 MPa, 10 MPa, 11 MPa, 12 MPa, or the like. It may be understood that the shear strength between the ultraviolet-curing tape layer 63 and the ink layer 52 and the shear strength between the ultraviolet-curing tape layer 63 and the middle bezel 20 may be the same or different.

During assembly, the ultraviolet-curing tape on which photocuring processing is not performed may be disposed on a side surface that is of the back cover 50 and that faces the middle bezel 20 (that is, an inner surface of the back cover 50), or the ultraviolet-curing tape on which photocuring processing is not performed may be disposed on a side surface that is of the middle bezel 20 and that faces the back cover 50, and ultraviolet light is used to irradiate a position of the ultraviolet-curing tape on the back cover 50 or the middle bezel 20, to perform ultraviolet activation on the ultraviolet-curing tape. Then, the back cover 50 is adhered to the middle bezel 20 by using the ultraviolet-curing tape obtained after photoactivation. Then, quick pressure maintaining is performed, by using a pressure maintaining fixture, on the back cover 50 and the middle bezel 20 that are adhered to each other. In a pressure maintaining process, the ultraviolet-curing tape is cured to form the ultraviolet-curing tape layer 63, so that the back cover 50 is fixedly adhered to the middle bezel 20.

A pressure maintaining time may be 60s~120s. For example, the pressure maintaining time may be 60s, 65s, 70s, 75s, 80s, 85s, 90s, 95s, 100s, 105s, 110s, 115s, 120s, or the like.

In the electronic device 100 in this application, the back cover 50 is fixedly adhered to the middle bezel 20 by using the ultraviolet-curing tape layer 63. In an assembly process, ultraviolet activation needs to be performed only on the ultraviolet-curing tape on which photocuring processing is not performed, and lamination processing is performed on the back cover 50 and the middle bezel 20, to assemble the back cover 50 and the middle bezel 20. Therefore, a process is simple, processing efficiency is high, and costs are low. In addition, compared with the pressure-sensitive tape 61 and the hot-melt adhesive 62, the ultraviolet-curing tape layer 63 and the ultraviolet-curing tape are easier to clean without residue, and a repair yield can be improved. In addition, in the electronic device 100 in this application, the shear strength between the ultraviolet-curing tape layer 63 and the ink layer 52 of the back cover 50 is set to be greater than or equal to 1.5 Mpa, and the shear strength between the ultraviolet-curing tape layer 63 and the middle bezel 20 is set to be greater than or equal to 1.5 Mpa, to ensure adhesive strength between the ultraviolet-curing tape layer 63 and each of the ink layer 52 and the middle bezel 20. Therefore, adhesive strength between the back cover 50 and the middle bezel 20 can be ensured, connection reliability between the back cover 50 and the middle bezel 20 is improved, and a risk that the back cover 50 is separated from the middle bezel 20 can be reduced in a scenario in which the electronic device 100 falls off or is impacted.

In this way, in the electronic device 100 in this application, on the basis of improving the connection reliability between the back cover 50 and the middle bezel 20, a process of assembling the back cover 50 and the middle bezel 20 can be simplified, and difficulty in assembling the back cover 50 and the middle bezel 20 can be reduced. Therefore, processing costs of the electronic device 100 can be reduced.

In some embodiments, the shear strength between the ultraviolet-curing tape layer 63 and the ink layer 52 of the back cover 50 is less than or equal to 7 Mpa. That is, a range of the shear strength between the ultraviolet-curing tape layer 63 and the ink layer 52 of the back cover 50 is 1.5 MPa~7 MPa. In this way, the adhesive strength and an anti-impact capability between the ultraviolet-curing tape layer 63 and the ink layer 52 can be moderate. Therefore, the connection reliability between the back cover 50 and the middle bezel 20 can be ensured, and the risk that the back cover 50 is separated from the middle bezel 20 can be effectively reduced when the electronic device 100 falls off or is impacted. In addition, when the electronic device 100 falls off or when the back cover 50 is detached in a repair process of the electronic device 100, the ink layer 52 on the back cover 50 can be prevented from being pulled off by the ultraviolet-curing tape layer 63. Therefore, a risk that the ink layer 52 is peeled off can be effectively reduced, and it is conducive to prolonging a service life of the electronic device 100.

In some embodiments, the shear strength between the ultraviolet-curing tape layer 63 and the middle bezel 20 is less than or equal to 7 Mpa. That is, a range of the shear strength between the ultraviolet-curing tape layer 63 and the middle bezel 20 is 1.5 MPa~7 MPa. In this way, difficulty in detaching the back cover 50 from the middle bezel 20 can be reduced, and the back cover 50 is easily detached from the middle bezel 20 in a repair process of the electronic device 100. Therefore, it is conducive to improving repair efficiency and shortening a repair time. In addition, a difference between the shear strength between the ultraviolet-curing tape layer 63 and the back cover 50 and the shear strength between the ultraviolet-curing tape layer 63 and the middle bezel 20 may be reduced, so that the adhesive strength between the ultraviolet-curing tape layer 63 and the back cover 50 and the adhesive strength between the ultraviolet-curing tape layer 63 and the middle bezel 20 can be balanced generally. Therefore, uniformity of force applied to the ultraviolet-curing tape layer 63 can be improved, and it is conducive to improving overall structural stability of the electronic device 100.

On the basis of any one of the foregoing embodiments, to further reduce the difficulty in assembling the electronic device 100, and improve an assembly yield of the electronic device 100, initial adhesion between the ultraviolet-curing tape and the ink layer 52 of the back cover 50 is greater than or equal to 0.2 N/mm. For example, the initial adhesion between the ultraviolet-curing tape and the ink layer 52 of the back cover 50 may be 0.2 N/mm, 0.3 N/mm, 0.4 N/mm, 0.5 N/mm, 0.6 N/mm, 0.7 N/mm, 0.8 N/mm, 0.9 N/mm, or 1.0 N/mm. The initial adhesion in this embodiment of this application refers to an adhesive effect of the ultraviolet-curing tape on an object when ultraviolet curing processing is not performed on the ultraviolet-curing tape and an adhesive surface of the ultraviolet-curing tape and the object are in short contact with a slight pressure. The initial adhesion may be tested with reference to GBIT 4852-2002 "Test Method for Tack of Pressure Sensitive Adhesive Tapes by Rolling Ball".

In this way, adhesive strength between the ultraviolet-curing tape on which photocuring processing is not performed and the back cover 50 can be ensured, and the ultraviolet-curing tape on which photocuring processing is not performed can be prevented from being slipped off from the back cover 50. Therefore, positioning reliability between the ultraviolet-curing tape on which photocuring processing is not performed and the back cover 50 can be improved, the difficulty in assembling the back cover 50 and the middle bezel 20 can be reduced, and an assembly yield of the electronic device 100 can be improved.

Further, the initial adhesion between the ultraviolet-curing tape and the ink layer 52 of the back cover 50 is less than or equal to 1.0 N/mm. In this way, difficulty in processing the ultraviolet-curing tape can be reduced, and processing costs of the ultraviolet-curing tape can be reduced. Therefore, overall costs of the electronic device 100 can be reduced.

In some embodiments, initial adhesion between the ultraviolet-curing tape and the middle bezel 20 may also be greater than or equal to 0.2 N/mm. Further, the initial adhesion between the ultraviolet-curing tape and the middle bezel 20 is less than or equal to 1.0 N/mm.

In some embodiments, a die-cuttable width of the ultraviolet-curing tape is less than 0.8 mm. Further, the die-cuttable width of the ultraviolet-curing tape is less than or equal to 0.5 mm. The die-cuttable width of the ultraviolet-curing tape is a die-cut width used for the ultraviolet-curing tape when photocuring processing is not performed on the ultraviolet-curing tape.

In this way, in actual application, die cutting may be performed on the ultraviolet-curing tape based on an actual requirement, so that the ultraviolet-curing tape is die-cut to a required width. Because the die-cuttable width of the ultraviolet-curing tape is small, different requirements of different adhesive parts for a width of the ultraviolet-curing tape layer 63 can be met, so that the middle bezel 20 can be more flexibly adhered to the back cover 50. Therefore, components inside the electronic device 100 are easily assembled, and it is conducive to enlarging an assembly space of the electronic device 100 for the components such as the battery 40 and the circuit board 30.

Refer to FIG. 7. In some embodiments, a width w of at least a part of the ultraviolet-curing tape layer 63 is less than 0.8 mm. That is, a width of a part of the ultraviolet-curing tape layer 63 may be less than 0.8 mm, or a width of the entire ultraviolet-curing tape layer 63 is less than 0.8 mm. Further, the width w of the at least a part of the ultraviolet-curing tape layer 63 may be less than or equal to 0.5 mm. In this way, an adhesive area between the back cover 50 and the middle bezel 20 is reduced, so that an assembly space for the components such as the battery 40 and the circuit board 30 can be enlarged without increasing an overall size of the electronic device 100, and sizes of the components such as the battery 40 and the circuit board 30 can be increased. Therefore, it is conducive to improving an endurance capability of the electronic device 100, expanding a function of the electronic device 100, and optimizing performance of the electronic device 100. In addition, it is further conducive to reducing the size of the electronic device 100, and implementing a thin and lightweight design of the electronic device 100.

Further, the width w of the at least a part of the ultraviolet-curing tape layer 63 is greater than or equal to 0.25 mm and less than or equal to 0.5 mm. For example, the width w of the at least a part of the ultraviolet-curing tape layer 63 may be 0.25 mm, 0.3 mm, 0.35 mm, 0.4 mm, 0.45 mm, 0.5 mm, or the like. In this way, the adhesive strength between the back cover 50 and the middle bezel 20 can be ensured, and an adhesive area between the back cover 50 and the middle bezel 20 is reduced, so that an assembly space for the components such as the battery 40 and the circuit board 30 can be enlarged without increasing an overall size of the electronic device 100, and sizes of the components such as the battery 40 and the circuit board 30 can be increased. Therefore, it is conducive to improving an endurance capability of the electronic device 100, expanding a function of the electronic device 100, and optimizing performance of the electronic device 100. In addition, it is further conducive to reducing the size of the electronic device 100, and implementing a thin and lightweight design of the electronic device 100.

Refer to FIG. 7. In some embodiments, a thickness t of the ultraviolet-curing tape layer 63 is greater than or equal to 0.15 mm and less than or equal to 0.45 mm. For example, the thickness of the ultraviolet-curing tape layer 63 may be 0.15 mm, 0.2 mm, 0.25 mm, 0.3 mm, 0.35 mm, 0.38 mm, 0.4 mm, 0.42 mm, 0.45 mm, or the like. A thickness direction of the ultraviolet-curing tape layer 63 is parallel to a thickness direction of the electronic device 100, that is, the thickness of the ultraviolet-curing tape layer 63 is parallel to the Z-axis direction.

In this way, photoactivation is easily performed on the ultraviolet-curing tape by using ultraviolet light, to ensure connection strength between the back cover 50 and the middle bezel 20, and improve an anti-fall capability of the electronic device 100. In addition, sizes of the middle bezel 20, the ultraviolet-curing tape layer 63, and the back cover 50 in the thickness direction (that is, the Z-axis direction) of the electronic device 100 can be reduced. In addition, a flatness problem in manufacturing the back cover 50 and the middle bezel 20 can be effectively absorbed by the ultraviolet-curing tape layer 63, and an assembly yield of the back cover 50 and the middle bezel 20 can be improved.

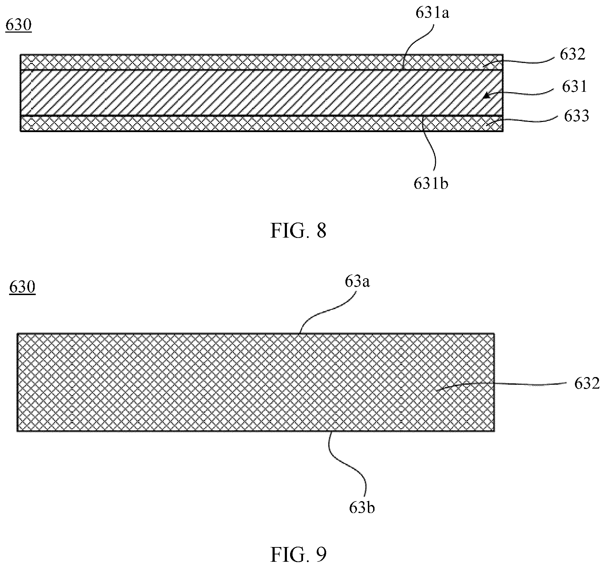

Refer to FIG. 8. FIG. 8 is a schematic diagram of a stacked structure of an ultraviolet-curing tape 630 according to some embodiments of this application. The ultraviolet-curing tape layer 63 may be formed after the ultraviolet-curing tape 630 is cured. The ultraviolet-curing tape 630 includes a matrix 631, a first adhesive film 632, and a second adhesive film 633. The matrix 631 includes a first surface 631a and a second surface 631b that face away from each other, the first adhesive film 632 is disposed on the first surface 631a, and the second adhesive film 633 is disposed on the second surface 631b. The first adhesive film 632 may be configured to be fixedly adhered to the back cover 50, and the second adhesive film 633 may be configured to be fixedly adhered to the middle bezel 20. The first adhesive film 632 and the second adhesive film 633 each include an ultraviolet-curing composition. Specifically, the first adhesive film 632 is fixedly adhered to the back cover 50 after being cured, and the second adhesive film 633 is fixedly adhered to the middle bezel 20 after being cured.

In this embodiment, the ultraviolet-curing tape 630 has a simple structure and is easy to process. In addition, the ultraviolet-curing composition in the first adhesive film 632 and the ultraviolet-curing composition in the second adhesive film 633 may be adjusted based on materials of the middle bezel 20 and the back cover 50, so that shear strength between the cured first adhesive film 632 and the ink layer 52 of the back cover 50 and shear strength between the cured second adhesive film 633 and the middle bezel 20 are moderate.

A thickness of the ultraviolet-curing tape 630 may be the same as the thickness of the ultraviolet-curing tape layer 63.

In some embodiments, the ultraviolet-curing composition in the first adhesive film 632 may be the same as the ultraviolet-curing composition in the second adhesive film 633. In this embodiment, the ultraviolet-curing composition of the first adhesive film 632 is used as an example for description.

Specifically, the ultraviolet-curing composition includes an acrylic polymer, a curable component, and a photo base generator. The acrylic polymer may include a methacrylic acid polymer. The curable component includes multi-functional thiol and multi-functional epoxy resin. Under ultraviolet irradiation, the photo base generator in the ultraviolet-curing composition may generate a basic catalyst, to catalyze the curable component in the ultraviolet-curing composition for reaction, thereby improving adhesive strength of the ultraviolet-curing tape layer 63 and the adhesive interface.

The multi-functional thiol in this embodiment of this application refers to a compound that has more than two mercapto (thiol) groups in a molecule. The multi-functional thiol may include but is not limited to: trimethylolpropane tris(3-mercaptopropionate), pentaerythritol tetrakis(3-mercaptopropionate), ethylene glycol bis(mercaptoacetate), 1,4-butanediol bis(thioglycolate), trimethylolpropane tris(2-mercaptoacetate), pentaerythritol tetrakis(2-mercaptoacetate), bis(2-mercaptoethyl) ether, 1,4-butanedithiol, 1,5-dimercapto-3-thiapentane, 1,8-dimercapto-3,6-dioxaoctane, 1,3,5-tris(mercaptomethyl)benzene, 4,4'-thiodibenzenethiol, 1,3,5-tris(mercaptomethyl)-2,4,6-trimethylbenzene, 2,4,6-trimethyl-s-triazine, 2-dibutylamino-4,6-dimercapto-s-triazine, pentaerythritol tetrakis(3-mercaptopropionate), dipentaerythritol hexakis(3-mercaptopropionate), polyether containing a terminal thiol group, polythioether containing a terminal thiol group, a mercaptan compound obtained through reaction of an epoxy compound with hydrogen sulfide, and a mercaptan compound that has a terminal thiol group and that is obtained through reaction of a polymercaptan compound with an epoxy compound.

The multi-functional epoxy resin is epoxy resin that has an average of more than two epoxy groups in each molecule. The multi-functional epoxy resin includes but is not limited to glycidyl ether-type epoxy resin containing etherified multi-functional phenol, glycidyl amine-type epoxy resin containing epoxidized multi-functional amine, glycidyl ester-type epoxy resin containing esterified multi-functional acid, alicyclic epoxy resin, and epoxidized polyolefin.

The photo base generator is a compound that can generate a basic substance under light irradiation. The photo base generator may include at least one of a cobalt-ammonia complex-type photo base generator, an oxime ester-type photo base generator, a quaternary ammonium salt-type photo base generator, or a borate-type photo base generator. The photo base generator in this embodiment of this application generates the basic catalyst to catalyze a curing reaction, the curing reaction is not as easily affected by moisture and basic substances as photo acid curing, does not cause corrosion to a surface of a metal substrate, and has high curing efficiency. A small amount of the photo base generator can catalyze a cross-linking reaction, to achieve strength of a semi-structural adhesive or a structural adhesive.

In some implementations, to improve the shear strength between the ultraviolet-curing tape layer 63 and the ink layer 52 of the back cover 50, a monomer of the acrylic polymer includes an acryloyl monomer containing a hydroxyl functional group. The acryloyl monomer is a monomer that contains an acryloyl group in a molecule. For example, the monomer of the acrylic polymer may include a monomer of hydroxyalkyl acrylate, for example, hydroxymethyl acrylate, hydroxyethyl acrylate, hydroxypropyl acrylate, hydroxybutyl acrylate, hydroxymethyl methacrylate, hydroxyethyl methacrylate, hydroxypropyl methacrylate, or hydroxybutyl methacrylate.

The hydroxyl functional group and the materials such as the major resin and the matte powder in the ink layer 52 have good wettability. When the monomer of the acrylic polymer includes the acryloyl monomer containing the hydroxyl functional group, wettability between the ultraviolet-curing composition and the ink layer 52 can be improved, and the shear strength between the ultraviolet-curing tape layer 63 and the back cover 50 can be improved, so that the ultraviolet-curing tape layer 63 can be applied to adhesion of interfaces such as a metal interface, a PC interface, and a PMMA interface, and can be applied to adhesion of an interface including the ink layer 52. Therefore, the ultraviolet-curing tape layer 63 can be applied to adhesion of a plurality of interfaces of different materials.

On the basis of the foregoing embodiment, to further improve the adhesive strength between the ultraviolet-curing tape layer 63 and the back cover 50 including the ink layer 52, a ratio of a mass of the acrylic polymer to a mass of the ultraviolet-curing composition is greater than or equal to 60% in the ultraviolet-curing tape layer 63. That is, a mass fraction of the acrylic polymer is greater than or equal to 60% after the ultraviolet-curing tape is cured. For example, the mass fraction of the acrylic polymer in the ultraviolet-curing tape layer 63 may be 60%, 62%, 65%, 68%, 70%, 72%, 75%, 78%, 80%, or the like.

In this way, the mass fraction of the acrylic polymer in the ultraviolet-curing tape layer 63 is set to be greater than or equal to 60%. In this case, the shear strength between the ultraviolet-curing tape layer 63 and the ink layer 52 of the back cover 50 can be controlled to be 1.5 MPa~7 MPa, the adhesive strength between the ultraviolet-curing tape layer 63 and the ink layer 52 can be significantly improved, and the ink layer 52 on the back cover 50 can be prevented from being pulled off by the ultraviolet-curing tape layer 63 in a scenario in which the electronic device 100 falls off or the back cover 50 is detached in a repair process of the electronic device 100. Therefore, a risk that the ink layer 52 is peeled off can be effectively reduced, and it is conducive to prolonging a service life of the electronic device 100. In addition, initial adhesion of the ultraviolet-curing tape 630 can be significantly improved, and positioning performance of the ultraviolet-curing tape can be improved.

In some embodiments, to easily perform ultraviolet activation on the ultraviolet-curing tape 630, light transmittance of the matrix 631 is greater than or equal to 92%. For example, the light transmittance of the matrix 631 may be 92%, 93%, 94%, 95%, 96%, 97%, 98%, 99%, or the like. In this way, when the ultraviolet-curing tape 630 is disposed on the back cover 50, the second adhesive film 633 may be exposed, so that the second adhesive film 633 can be directly activated by using ultraviolet light, and the first adhesive film 632 can be activated by using the ultraviolet light passing through the matrix 631. Similarly, when the ultraviolet-curing tape 630 is disposed on the middle bezel 20, the first adhesive film 632 may be exposed, so that the first adhesive film 632 can be directly activated by using ultraviolet light, and the second adhesive film 633 can be activated by using the ultraviolet light passing through the matrix 631.

In some embodiments, the matrix 631 is a transparent plastic member. A material of the matrix 631 may include at least one of polyethylene terephthalate (polyethylene terephthalate, PET), polymethyl methacrylate (polymethyl methacrylate, PMMA), or polycarbonate (polycarbonate, PC). That is, the material of the matrix 631 may include one of PET, PMMA, and PC. Alternatively, the material of the matrix 631 may include two of PET, PMMA, and PC, or the material of the matrix 631 may include PET, PMMA, and PC. These materials have good light transmittance, low prices, and are easy to obtain.

It may be understood that, in another embodiment, refer to FIG. 9. FIG. 9 is a schematic diagram of a structure of the ultraviolet-curing tape 630 according to some other embodiments of this application. The ultraviolet-curing tape 630 may not include the matrix 631. In this case, the ultraviolet-curing tape 630 may include only the first adhesive film 632. That is, the ultraviolet-curing tape layer 63 is a matrix-free adhesive film. It may be understood that, in another embodiment, the ultraviolet-curing tape 630 may alternatively include only the second adhesive film 633.

Specifically, refer to FIG. 9. The first adhesive film 632 includes a first adhesive surface 63a and a second adhesive surface 63b. The first adhesive surface 63a may be adhered to the back cover 50, and the second adhesive surface 63b may be adhered to the middle bezel 20. In this way, the middle bezel 20 can also be fixedly adhered to the back cover 50, and the ultraviolet-curing tape 630 has a simple structure, and is easy to process.

In the electronic device 100 in this embodiment of this application, the middle bezel 20 is fixedly adhered to the back cover 50 by using the ultraviolet-curing tape layer 63. In this way, the ultraviolet-curing tape layer 63 can be adapted to adhesion of a plurality of interfaces, has adhesive strength obviously better than that of the pressure-sensitive tape 61, and can reduce the risk that the back cover 50 is separated from the middle bezel 20 in a fall-off and impact scenario of the user. In addition, the adhesive strength and an anti-impact capability between the ultraviolet-curing tape layer 63 and each of the back cover 50 and the middle bezel 20 are moderate, and a problem that the ink layer 52 is peeled off due to excessively high adhesive strength does not occur. In addition, compared with an adhesion solution implemented by using the pressure-sensitive tape 61, an adhesion solution implemented by performing adhesive dispensing by using the hot-melt adhesive 62, and an adhesion solution in which the pressure-sensitive tape 61 and the hot-melt adhesive 62 are combined, in an adhesion solution implemented by using the ultraviolet-curing tape layer 63, the electronic device 100 has high assembly and processing efficiency and low costs, the ultraviolet-curing tape layer 63 and the ultraviolet-curing tape 630 used to form the ultraviolet-curing tape layer 63 are easier to clean without residue or adhesive overflow, and a repair yield can be improved. In addition, the die-cuttable width of the ultraviolet-curing tape 630 used to form the ultraviolet-curing tape layer 63 is small, and may be less than or equal to 0.5 mm, which can meet a requirement of the electronic device 100 for the width of the ultraviolet-curing tape layer 63. Therefore, it is conducive to enlarging a mounting space of the electronic device for the components such as the battery 40 and the circuit board 30, and it is conducive to implementing a thin and lightweight design of the electronic device 100.

An embodiment of this application further provides an assembly method for an electronic device 100. The electronic device 100 in this embodiment may be the electronic device 100 in any one of the foregoing embodiments.

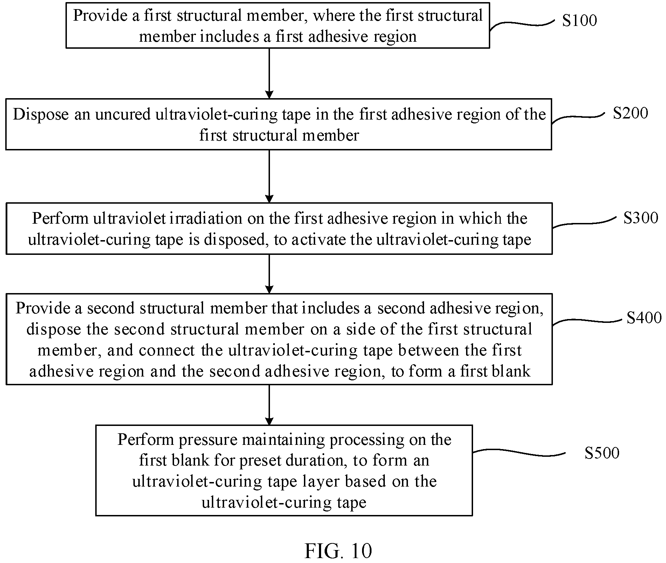

Refer to FIG. 10. FIG. 10 is a flowchart of an assembly method for an electronic device according to some embodiments of this application. The assembly method for an electronic device includes:
Step S 100: Provide a first structural member, where the first structural member includes a first adhesive region.
Step S200: Dispose an uncured ultraviolet-curing tape in the first adhesive region of the first structural member.
Step S300: Perform ultraviolet irradiation on the first adhesive region in which the ultraviolet-curing tape is disposed, to activate the ultraviolet-curing tape.
Step S400: Provide a second structural member that includes a second adhesive region, dispose the second structural member on a side of the first structural member, and connect the ultraviolet-curing tape between the first adhesive region and the second adhesive region, to form a first blank.
Step S500: Perform pressure maintaining processing on the first blank for preset duration, to form an ultraviolet-curing tape layer based on the ultraviolet-curing tape. Specifically, in a process of performing pressure maintaining processing on the first blank, the ultraviolet-curing tape may be cured to form the ultraviolet-curing tape layer.

In some embodiments, shear strength between the ultraviolet-curing tape layer and the first adhesive region is greater than or equal to 1.5 Mpa, and shear strength between the ultraviolet-curing tape layer and the second adhesive region is greater than or equal to 1.5 Mpa. In this way, adhesive strength between the ultraviolet-curing tape layer and each of the first adhesive region and the second adhesive region can be ensured. Therefore, connection reliability between the first structural member and the second structural member can be ensured.

In some embodiments, the first structural member includes a back cover, and the second structural member includes a middle bezel. In this case, the first adhesive region is located on an ink layer of the back cover, and the second adhesive region is located on the middle bezel. Alternatively, in some other embodiments, the first structural member may include a middle bezel, and the second structural member may include a back cover. In this case, the first adhesive region is located on the middle bezel, and the second adhesive region is located on an ink layer of the back cover.

It may be understood that a structural member including the middle bezel may further include a battery, a circuit board, and the like that are disposed on the middle bezel. Certainly, it may be understood that, in another embodiment, a structural member including the middle bezel may alternatively include only the middle bezel, but does not include another component.

In the assembly method for an electronic device in this application, in an assembly process, photoactivation needs to be performed only on the uncured ultraviolet-curing tape, and lamination processing is performed on the first structural member and the second structural member, to assemble the first structural member and the second structural member. Therefore, a process is simple, processing efficiency is high, and costs are low. In addition, the ultraviolet-curing tape layer is formed after the ultraviolet-curing tape is cured, so that connection strength between the first structural member and the second structural member can be ensured. Therefore, adhesive strength between the back cover and the middle bezel can be ensured, connection reliability between the back cover and the middle bezel is improved, and a risk that the back cover is separated from the middle bezel can be reduced in a scenario in which the electronic device falls off or is impacted. In addition, compared with a pressure-sensitive tape and a hot-melt adhesive, the ultraviolet-curing tape layer and the ultraviolet-curing tape are easier to clean without residue, and a repair yield of the electronic device can be improved.

In some embodiments, initial adhesion between the ultraviolet-curing tape and the first adhesive region is greater than or equal to 0.2 N/mm. Specifically, when the first adhesive region is located on the ink layer, initial adhesion between the ultraviolet-curing tape and the ink layer is greater than or equal to 0.2 N/mm. When the first adhesive region is located on the middle bezel, initial adhesion between the ultraviolet-curing tape and the middle bezel is greater than or equal to 0.2 N/mm. In this way, adhesive strength between the uncured ultraviolet-curing tape and the first adhesive region can be ensured, the uncured ultraviolet-curing tape can be prevented from being slipped off from the first adhesive region, and positioning reliability between the uncured ultraviolet-curing tape and the first structural member can be improved. Therefore, difficulty in assembling the electronic device can be reduced, and it is conducive to improving an assembly yield of the electronic device.

A stacked structure, a thickness, a die-cuttable width, and an ultraviolet-curing composition of the ultraviolet-curing tape may be designed with reference to the ultraviolet-curing tape in any one of the foregoing embodiments. Details are not described herein again.

In some embodiments, the performing pressure maintaining processing on the first blank for preset duration includes: performing pressure maintaining processing on the first blank by using a pressure maintaining fixture for 60s~120s. For example, a pressure maintaining time may be 60s, 65s, 70s, 75s, 80s, 85s, 90s, 95s, 100s, 105s, 110s, 115s, 120s, or the like. In this way, adhesive strength between the first structural member and the second structural member can be ensured, and an overall assembly time of the electronic device is shortened. This is conducive to improving assembly efficiency of the electronic device.

The following describes in detail the assembly method including the electronic device 100 with reference to a specific embodiment.

### Embodiment 1

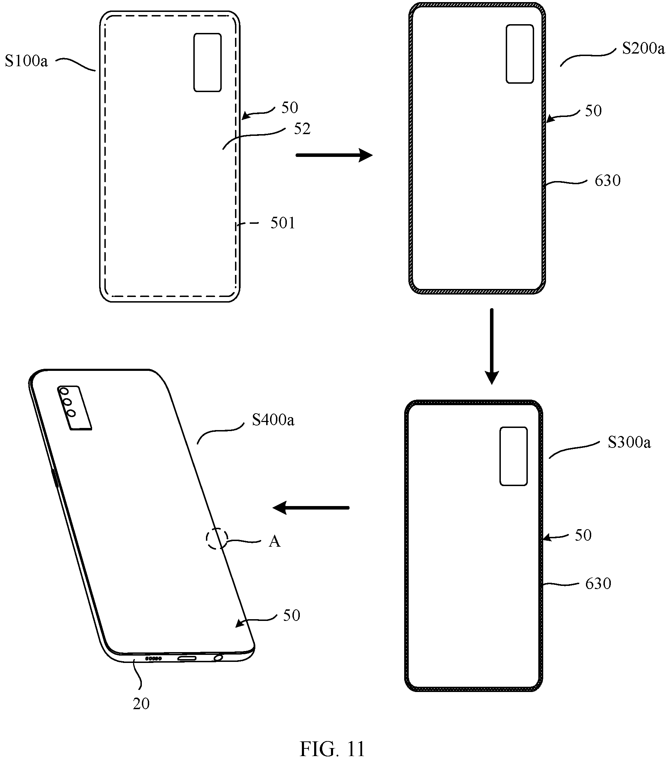

Refer to FIG. 11. FIG. 11 is a schematic flowchart of an assembly method for an electronic device 100 according to some embodiments of this application. The assembly method for an electronic device 100 includes the following steps.

Step S 100a: Provide a first structural member, where the first structural member includes a back cover 50, the back cover 50 includes an ink layer 52, and a first adhesive region 501 is disposed on the ink layer 52.

Materials of the ink layer include major resin and matte powder. The first adhesive region 501 is located on an edge part of the back cover 50. Optionally, the first adhesive region 501 is in a ring shape.

Step S200a: Dispose an ultraviolet-curing tape 630 in the first adhesive region 501 on the ink layer 52.

In this embodiment, the cured ultraviolet-curing tape 630 is a matrix-free adhesive film.

Step S300a: Perform ultraviolet irradiation on the first adhesive region 501 in which the ultraviolet-curing tape 630 is disposed, to activate the ultraviolet-curing tape 630.

Step S400a: Provide a second structural member that includes a middle bezel 20 on which a second adhesive region is disposed, dispose the second structural member on a side of the first structural member, and connect the ultraviolet-curing tape 630 between the first adhesive region 501 and the second adhesive region, to form a first blank; and perform pressure maintaining processing on the first blank by using a pressure maintaining fixture for 90s.

It may be understood that the ultraviolet-curing tape 630 in step S400a is an ultraviolet-curing tape 630 that is activated through ultraviolet irradiation.

In some embodiments, before the disposing the second structural member on a side of the first structural member, the method further includes: assembling components such as a battery, a circuit, and a screen on the middle bezel.

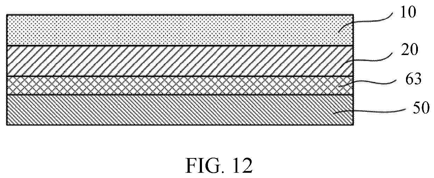

Refer to FIG. 12. FIG. 12 is an enlarged view of a region A in the schematic flowchart shown in FIG. 11. The ultraviolet-curing tape layer 63 (that is, the cured ultraviolet-curing tape) is connected between the middle bezel 20 and the back cover 50, and the screen 10 is connected to a side that is of the middle bezel 20 and that faces away from the back cover 50.

For performance of the electronic device 100, see Table 1.

### Comparative Example 1

An assembly method for an electronic device includes:
Step S100b: Provide a first structural member, where the first structural member includes a back cover, the back cover includes an ink layer, and a first adhesive region is disposed on the ink layer.
Step S200b: Dispose a pressure-sensitive tape in the first adhesive region on the ink layer.
Step S300b: Provide a second structural member that includes a middle bezel on which a second adhesive region is disposed, dispose the second structural member on a side that is of the first structural member and that faces away from the pressure-sensitive tape, connect the pressure-sensitive tape between the first adhesive region and the second adhesive region, to form a second blank, and perform pressure maintaining processing on the second blank by using a pressure maintaining fixture.

For performance of the electronic device, see Table 1.

**Table 1**

| | Adhesive structure | | | Shear strength between the adhesive structure and the back cover | Tumbling performance |
|---|---|---|---|---|---|
| Embodiment 1 | Ultraviolet-curing tape layer | Thickness | 0.3 mm | 3.58 Mpa | Greater than 2000 times |
| | | Initial adhesion | 0.35 N/mm | | |
| | | Mass fraction of an acrylic polymer | 60% | | |
| | | Monomer of the acrylic polymer | Acryloyl monomer containing a hydroxyl functional group is included | | |
| Comparative Example 1 | Pressure-sensitive tape | Thickness | 0.3 mm | 1.1 Mpa | 450 times |

It can be learned from Table 1 that, in Embodiment 1, the adhesive structure between the middle bezel and the back cover in the electronic device is the ultraviolet-curing tape layer, and the thickness of the ultraviolet-curing tape layer is 0.3 mm. When ultraviolet curing is not performed on the ultraviolet-curing tape, the initial adhesion between the ultraviolet-curing tape and the ink layer is 0.35 N/mm. In an ultraviolet-curing composition of the ultraviolet-curing tape layer, a mass fraction of the acrylic polymer is 60%, and the monomer of the acrylic polymer includes the acryloyl monomer containing a hydroxyl functional group.

In the electronic device in Embodiment 1, connection reliability between the back cover and the middle bezel is strong, and the electronic device performs excellent anti-fall performance in a tumbling performance test. Specifically, shear strength between the ink layer of the back cover and the ultraviolet-curing tape layer is 3.58 MPa. When the electronic device falls off for 2000 times in the tumbling performance test, the back cover is not separated from the middle bezel.

The initial adhesion between the ultraviolet-curing tape and the ink layer may be tested with reference to GB/T4852-2002 "Test Method for Tack of Pressure Sensitive Adhesive Tapes by Rolling Ball". The shear strength between the back cover and the ultraviolet-curing tape layer may be tested with reference to GBIT 33332-2016 "Test Method for Dynamic Shear Strength of Adhesive Tapes". The tumbling test refers to performing continuous tumbling and falling tests on the entire electronic device by using a tumbling tester. After a quantity of times set by a counter is reached, the entire electronic device is taken out to evaluate anti-tumbling and anti-fall capabilities of the entire electronic device.

In Comparative Example 1, the adhesive structure between the middle bezel and the back cover in the electronic device is the pressure-sensitive tape, and the thickness and the width of the pressure-sensitive tape are 0.3 mm and 0.8 mm, respectively. For the electronic device in Comparative Example 1, connection reliability between the back cover and the middle bezel is poor, and performance of the electronic device in the tumbling performance test is poor. Specifically, the shear strength between the back cover and the pressure-sensitive tape is 1.1 MPa. When the electronic device falls off for 450 times in the tumbling performance test, the back cover is separated from the middle bezel.

It can be learned from the foregoing descriptions that, when the ultraviolet-curing tape layer is used to adhere the back cover to the middle bezel, the connection reliability between the middle bezel and the back cover can be improved, and anti-impact performance of the electronic device can be improved. When the electronic device falls off, the back cover can be effectively prevented from being separated from the middle bezel.

In the descriptions of this specification, specific features, structures, materials, or characteristics may be properly combined in any one or more embodiments or examples.

Finally, it should be noted that the foregoing embodiments are only used to illustrate the technical solutions in this application, but are not used to limit this application. Although this application has been described in detail with reference to the foregoing embodiments, it should be understood by a person of ordinary skill in the art that the technical solutions described in the foregoing embodiments may still be modified, or some technical features thereof may be equivalently replaced. These modifications or replacements do not make the essence of the corresponding technical solutions depart from the spirit and scope of the technical solutions in embodiments of this application.

## Claims

1. An electronic device, comprising:
a middle bezel;
a back cover, wherein the back cover is disposed on a side of the middle bezel, the back cover comprises a substrate and an ink layer, and the ink layer is disposed on a side surface that is of the substrate and that faces the middle bezel; and
an ultraviolet-curing tape layer, wherein the back cover is fixedly adhered to the middle bezel by using the ultraviolet-curing tape layer, the ultraviolet-curing tape layer is connected between the ink layer and the middle bezel, shear strength between the ultraviolet-curing tape layer and the ink layer is greater than or equal to 1.5 MPa, and shear strength between the ultraviolet-curing tape layer and the middle bezel is greater than or equal to 1.5 MPa.

2. The electronic device according to claim 1, wherein the shear strength between the ultraviolet-curing tape layer and the ink layer is less than or equal to 7 MPa.

3. The electronic device according to claim 1, wherein the shear strength between the ultraviolet-curing tape layer and the middle bezel is less than or equal to 7 MPa.

4. The electronic device according to claim 1, wherein a width of at least a part of the ultraviolet-curing tape layer is less than 0.8 mm.

5. The electronic device according to claim 1, wherein a width of at least a part of the ultraviolet-curing tape layer is greater than or equal to 0.25 mm and less than or equal to 0.5 mm.

6. The electronic device according to claim 1, wherein a thickness of the ultraviolet-curing tape layer is greater than or equal to 0.15 mm and less than or equal to 0.45 mm.

7. The electronic device according to claim 1, wherein the ultraviolet-curing tape layer is formed by performing photocuring processing on an ultraviolet-curing tape, and the ultraviolet-curing tape comprises:
a matrix, wherein the matrix is a transparent member, and the matrix comprises a first surface and a second surface that are opposite to each other, and the first surface faces the back cover;
a first adhesive film, wherein the first adhesive film is disposed on the first surface of the matrix, and the first adhesive film is configured to be fixedly adhered to the back cover; and
a second adhesive film, wherein the second adhesive film is disposed on the second surface of the matrix, the second adhesive film is configured to be fixedly adhered to the middle bezel, and the first adhesive film and the second adhesive film each comprise an ultraviolet-curing composition.

8. The electronic device according to claim 7, wherein light transmittance of the matrix is greater than or equal to 92%.

9. The electronic device according to claim 1, wherein the ultraviolet-curing tape layer is formed by performing photocuring processing on an ultraviolet-curing tape, the ultraviolet-curing tape comprises a first adhesive film, the first adhesive film comprises an ultraviolet-curing composition, the first adhesive film comprises a first adhesive surface and a second adhesive surface that face away from each other, the first adhesive surface is configured to be adhered to the back cover, and the second adhesive surface is configured to be adhered to the middle bezel.

10. The electronic device according to any one of claims 7-9, wherein the ultraviolet-curing composition comprises:
an acrylic polymer, wherein a monomer of the acrylic polymer comprises an acryloyl monomer containing a hydroxyl functional group;
a curable component, wherein the curable component comprises multi-functional thiol and multi-functional epoxy resin; and
a photo base generator.

11. The electronic device according to claim 10, wherein in the ultraviolet-curing tape layer, a ratio of a mass of the acrylic polymer to a mass of the ultraviolet-curing composition is greater than or equal to 60%.

12. The electronic device according to any one of claims 1-9, wherein the middle bezel comprises a middle plate and a bezel, the bezel is connected to an outer edge of the middle plate, and the ultraviolet-curing tape layer is connected between the middle plate and the back cover.

13. The electronic device according to claim 12, wherein the middle plate is a metal member, a polymethyl methacrylate member, or a polycarbonate member.

14. An assembly method for the electronic device according to any one of claims 1-13, comprising:
providing a first structural member, wherein the first structural member comprises a first adhesive region;
disposing an uncured ultraviolet-curing tape in the first adhesive region of the first structural member;
performing ultraviolet irradiation on the first adhesive region in which the ultraviolet-curing tape is disposed, to activate the ultraviolet-curing tape;
providing a second structural member that comprises a second adhesive region, disposing the second structural member on a side of the first structural member, and connecting the ultraviolet-curing tape between the first adhesive region and the second adhesive region, to form a first blank; and
performing pressure maintaining processing on the first blank for preset duration, to form an ultraviolet-curing tape layer based on the ultraviolet-curing tape, wherein
the first structural member comprises the back cover, the second structural member comprises the middle bezel, the first adhesive region is located on the ink layer of the back cover, and the second adhesive region is located on the middle bezel; or the first structural member comprises the middle bezel, the second structural member comprises the back cover, the first adhesive region is located on the middle bezel, and the second adhesive region is located on the ink layer of the back cover.

15. The assembly method for the electronic device according to claim 14, wherein the performing pressure maintaining processing on the first blank for preset duration comprises:
performing pressure maintaining processing on the first blank by using a pressure maintaining fixture for 60s~120s.

16. The assembly method for the electronic device according to claim 14, wherein initial adhesion between the ultraviolet-curing tape and the first adhesive region is greater than or equal to 0.2 N/mm.

17. The assembly method for the electronic device according to any one of claims 14-16, wherein a die-cuttable width of the ultraviolet-curing tape is less than or equal to 0.5 mm.

18. An electronic device, comprising:
a middle bezel;
a back cover, wherein the back cover is disposed on a side of the middle bezel, the back cover comprises a substrate and an ink layer, and the ink layer is disposed on a side surface that is of the substrate and that faces the middle bezel; and
an ultraviolet-curing tape layer, wherein the back cover is fixedly adhered to the middle bezel by using the ultraviolet-curing tape layer, the ultraviolet-curing tape layer is connected between the ink layer and the middle bezel, the ultraviolet-curing tape layer comprises an ultraviolet-curing composition, the ultraviolet-curing composition comprises an acrylic polymer, a curable component, and a photo base generator, a monomer of the acrylic polymer comprises an acryloyl monomer containing a hydroxyl functional group, a ratio of a mass of the acrylic polymer to a mass of the ultraviolet-curing composition is greater than or equal to 60% and less than 80%, and the curable component comprises multi-functional thiol and multi-functional epoxy resin; and
shear strength between the ultraviolet-curing tape layer and the ink layer is greater than or equal to 1.5 MPa and less than or equal to 7 MPa, and shear strength between the ultraviolet-curing tape layer and the middle bezel is greater than or equal to 1.5 MPa.

19. The electronic device according to claim 18, wherein the shear strength between the ultraviolet-curing tape layer and the middle bezel is less than or equal to 7 MPa.

20. The electronic device according to claim 18, wherein a width of at least a part of the ultraviolet-curing tape layer is less than 0.8 mm.

21. The electronic device according to claim 18, wherein a width of at least a part of the ultraviolet-curing tape layer is greater than or equal to 0.25 mm and less than or equal to 0.5 mm.

22. The electronic device according to claim 18, wherein a thickness of the ultraviolet-curing tape layer is greater than or equal to 0.15 mm and less than or equal to 0.45 mm.

23. The electronic device according to claim 18, wherein the ultraviolet-curing tape layer is formed by performing photocuring processing on an ultraviolet-curing tape, and the ultraviolet-curing tape comprises:
a matrix, wherein the matrix is a transparent member, and the matrix comprises a first surface and a second surface that are opposite to each other, and the first surface faces the back cover;
a first adhesive film, wherein the first adhesive film is disposed on the first surface of the matrix, and the first adhesive film is configured to be fixedly adhered to the back cover; and
a second adhesive film, wherein the second adhesive film is disposed on the second surface of the matrix, the second adhesive film is configured to be fixedly adhered to the middle bezel, and the first adhesive film and the second adhesive film each comprise an ultraviolet-curing composition.

24. The electronic device according to claim 23, wherein light transmittance of the matrix is greater than or equal to 92%.

25. The electronic device according to claim 18, wherein the ultraviolet-curing tape layer is formed by performing photocuring processing on an ultraviolet-curing tape, the ultraviolet-curing tape comprises a first adhesive film, the first adhesive film comprises an ultraviolet-curing composition, the first adhesive film comprises a first adhesive surface and a second adhesive surface that face away from each other, the first adhesive surface is configured to be adhered to the back cover, and the second adhesive surface is configured to be adhered to the middle bezel.

26. The electronic device according to any one of claims 18-25, wherein the middle bezel comprises a middle plate and a bezel, the bezel is connected to an outer edge of the middle plate, and the ultraviolet-curing tape layer is connected between the middle plate and the back cover.

27. The electronic device according to claim 26, wherein the middle plate is a metal member, a polymethyl methacrylate member, or a polycarbonate member.
